# EUROPEAN PATENT SPECIFICATION

(11) **EP 4 488 224 B1**
(45) Date of publication and mention of the grant of the patent: **21.10.2026**
(21) Application number: 24181025.8
(22) Date of filing: 10.06.2024
(51) Int. Cl.: B81B 7/02

(54) **MANUFACTURING PROCESS FOR MICROELECTROMECHANICAL SENSOR DEVICE WITH WAFER-LEVEL INTEGRATION OF PRESSURE AND INERTIAL DETECTION STRUCTURES**
HERSTELLUNGSVERFAHREN FÜR MIKROELEKTROMECHANISCHE SENSORVORRICHTUNG MIT INTEGRATION VON DRUCK- UND TRÄGHEITSERFASSUNGSSTRUKTUREN AUF WAFEREBENE
PROCÉDÉ DE FABRICATION D'UN DISPOSITIF DE CAPTEUR MICROÉLECTROMÉCANIQUE AVEC INTÉGRATION AU NIVEAU DE LA TRANCHE DE STRUCTURES DE DÉTECTION DE PRESSION ET D'INERTIE

(30) Priority: 28.06.2023 IT 202300013389
(43) Date of publication of application: 08.01.2025
(73) Proprietor: STMicroelectronics International N.V., 1228 Plan-les-Ouates, Geneva (CH)
(72) Inventor: ALLEGATO, Giorgio, 20900 Monza (MB) (IT); FERRARI, Paolo, 21013 Gallarate (VA) (IT); OGGIONI, Laura, 20149 Milano (IT)
(74) Representative: Studio Torta S.p.A.

(56) References cited:
- US-A1- 2008 030 205
- US-A1- 2015 061 049
- US-A1- 2016 297 673
- US-A1- 2021 246 012
- US-B2- 9 908 771

## Description

### TECHNICAL FIELD

The present invention relates to a manufacturing process of a microelectromechanical sensor device with wafer-level integration of a pressure-detection structure and an inertial detection structure;

### CONTEXT

As is known, current micromachining techniques enable manufacturing of microelectromechanical systems (MEMS) starting from layers of semiconductor material, which have been deposited (for example, a layer of polycrystalline silicon) or grown (for example, an epitaxial layer) on sacrificial layers, which are then removed via chemical etching. Inertial sensors, such as accelerometers, resonators or gyroscopes, obtained with this technology are witnessing a growing success, for example, in the automotive field, in inertial navigation, or in the field of portable devices for consumer electronics (so-called consumer applications).

Pressure sensors made with MEMS technology are also known, typically comprising a membrane made in a die of semiconductor material, suspended above a cavity so as to undergo deformation in response to incident pressure waves. Detection elements, for example piezoresistors, formed at this membrane provide an electrical detection signal indicative of the value of the pressure acting on the sensor.

In particular, solutions are known, which envisage integration in a same package of an inertial detection structure (for example, an accelerometer or a gyroscope) and of a pressure-detection structure, to provide complex detection units for several applications that range, for example, from the automotive field to the field of consumer electronics.

For instance, a MEMS accelerometer and a pressure sensor have been integrated at the package level to obtain a tyre-pressure monitoring system (TPMS) for motor vehicles. Furthermore, movement-detection units are known that enclose, in a same package, inertial detection and pressure-detection structures to obtain inertial measurement units (IMUs) with a number of degrees of freedom.

Integration in a same package of a number of MEMS detection structures, in particular of a pressure-detection structure and an inertial detection structure, poses, however, some problems, in particular as regards the size and space occupation of the resulting devices and moreover as regards compatibility of the manufacturing techniques.

In this regard, different sensors, in particular inertial sensors and pressure sensors, may have different principles of operation and technical requirements. For this reason, typically different front-end manufacturing technologies are used to manufacture these devices (where by "front-end" are meant the steps of processing the wafers of semiconductor material of the sensors to produce the corresponding detection structures).

Use of different technologies has the advantage of removing constraints deriving from integration of processes of different devices and of providing greater flexibility to each technology for producing the sensors and achieving the final performance.

For the reasons outlined above, the detection structures, after being made in the respective dies, are commonly integrated at the package level, with back-end techniques (where by "back-end" are meant the final steps of packaging of the dies that have already been machined, where the corresponding detection structures have already been provided, these steps including, for example, mechanical coupling of the same dies to a leadframe of the package, electrical coupling by wire bonding, and application of coating or some other type of encapsulating covering).

Within the same package a further die, integrating an electronic ASIC (Application-Specific Integrated Circuit) may moreover be enclosed, electrically coupled to the various sensors (for example, the pressure and inertial sensors) for carrying out appropriate processing operations (for example, operations of filtering, amplification, comparison with thresholds, etc.) of the detection signals provided by the corresponding detection structures and for supplying output signals to external electronic systems.

This integration at the package level typically follows two approaches.

A first approach envisages positioning side by side of the MEMS dies integrating the various detection structures, with a consequent increase in space occupation in the horizontal plane of the final package.

A second approach envisages a stacking in the vertical direction of the MEMS dies, with a consequent increase in the thickness of the final package.

In the latter case, since the inertial detection structures require a hermetic package, the stack is typically made up of at least three substrates: a first substrate where the inertial detection structure is provided; a second substrate, which operates as cap of the same inertial detection structure; and a third substrate where the pressure-detection structure is provided.

In general, the need is felt to provide an improved solution for integration in a same package of different MEMS sensors, in particular of a pressure-detection structure and an inertial detection structure, enabling reduction of the dimensions of the resulting package and at the same time not posing constraints on the realization of the same detection structures.

US 2015/061049 A1 discloses a micromechanical sensor device having a capacitive sensor device with first and second electrodes. The first electrode is at least partially formed from a first semiconductor layer and/or metal layer, and at least one inner side of the second electrode facing the first electrode is formed from a second semiconductor layer and/or metal layer. A cavity is between the first and second electrodes. Continuous recesses are structured into the inner side of the second electrode and sealed off with a closure layer. In addition, the micromechanical sensor device comprises an acceleration sensor or a rotation rate sensor.

### SUMMARY

The aim of the present solution is to solve, at least in part, the problems highlighted previously and to meet the aforesaid need.

According to the present invention, a manufacturing process of a microelectromechanical sensor device with wafer-level integration of a pressure-detection structure and an inertial detection structure is consequently provided, as defined in the annexed claims.

### BRIEF DESCRIPTION OF THE DRAWINGS

For a better understanding of the present invention, a preferred embodiment thereof is now described, purely by way of non-limiting example and with reference to the attached drawings, wherein:
- Figure 1 is a schematic cross-sectional view of a stack formed by a pressure-detection structure and an inertial detection structure, according to an aspect of the present solution;
- Figure 2 is a schematic cross-sectional view of the stack of Figure 1 in a corresponding package of a microelectromechanical sensor device;
- Figures 3A-3I are schematic cross-sectional views of the stack of Figure 1 in successive steps of a manufacturing process; and
- Figure 4 is a schematic cross-sectional view of an alternative step of the manufacturing process.

### DESCRIPTION OF EMBODIMENTS

As will be described in detail hereinafter, an aspect of the present solution envisages wafer-level integration of different MEMS sensors, in particular of a pressure sensor and of an inertial sensor, before dicing of the corresponding wafers of semiconductor material for formation of the respective dies and prior to back-end manufacturing steps, i.e., for packaging within a corresponding package.

In particular, a first wafer of semiconductor material, where a detection structure of a pressure sensor has previously been formed, is stacked (via appropriate bonding) to a second wafer of semiconductor material, where a detection structure of an inertial sensor has previously been formed.

The two stacked wafers, after possible further specific bonding steps (which will be described hereinafter), then undergo dicing.

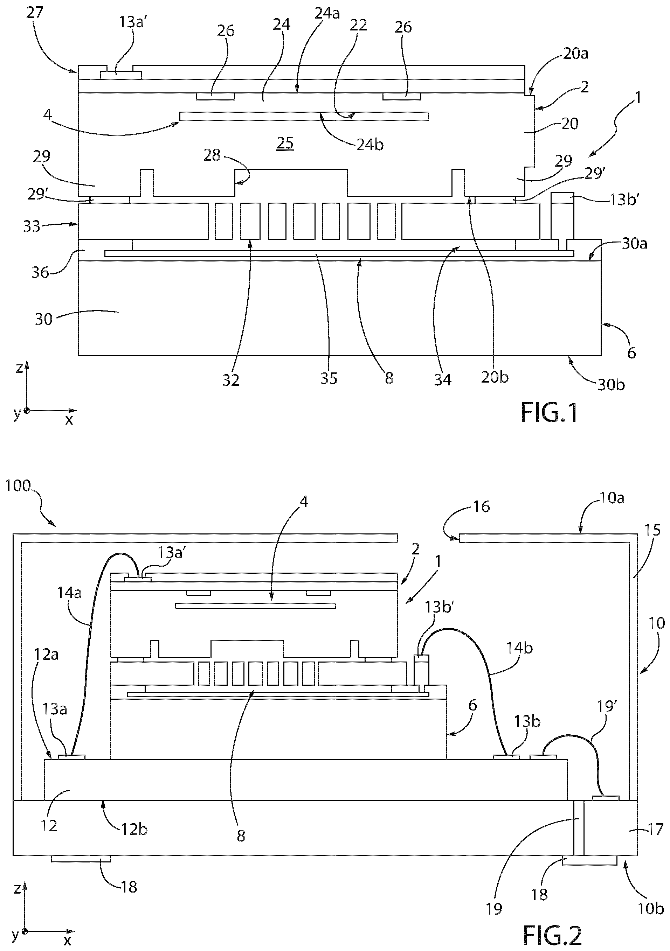

As illustrated schematically in Figure 1, the aforesaid dicing leads to formation of a stack 1 made up of a first die 2, which integrates a pressure-detection structure 4, which is bonded (as a result of the previous bonding between the wafers) to a second die 6 of semiconductor material, which integrates an inertial detection structure 8, that implements, for example, an accelerometer, a gyroscope, a resonator or an appropriate combination of these sensors (for example, the combination of a triaxial accelerometer and of a triaxial gyroscope).

According to an aspect of the present solution, in the aforesaid stack 1 the first die 2 is a cap for the underlying inertial detection structure 8 so as to define a hermetic environment required for operation of the same inertial detection structure 8.

As illustrated schematically in Figure 2, back-end manufacturing steps may then lead to the manufacturing of a package 10 of a resulting microelectromechanical sensor device 100, where the aforesaid stack 1 is attached, for example by die attach, to a third die 12, which integrates an electronic ASIC circuit, electrically coupled to the first die 2 (and to the corresponding pressure-detection structure 4) and to the second die 6 (and to the corresponding inertial detection structure 8) by respective electrical-connection wires using the wire-bonding technique.

In particular, first electrical-connection wires 14a connect first pads 13a carried by a top surface 12a of the third die 12 to respective pads 13a' carried by the first die 2 (and electrically connected to the pressure-detection structure 4), and second electrical-connection wires 14b connect second pads 13b carried by the top surface 12a of the third die 12 to respective pads 13b' carried by the second die 4 (and electrically connected to the inertial detection structure 8).

The resulting arrangement of the stack 1 may be set within a cavity-type encapsulation 15, which includes, at a top surface, an access hole 16 to convey pressure towards the pressure-detection structure 4 in the first die 2 (in particular, towards a corresponding detection membrane). As an alternative, the resulting arrangement of the stack 1 may be covered with a coating (acting in this case as encapsulation material), for example, made of epoxy resin, which may coat at the top the third die 12 and laterally the stack 1 formed by the first and second dies 2, 6, and may moreover coat at the top the aforesaid first die 2. Also in this case, a front surface 10a of the package 10, defined by the aforesaid coating, has an access hole to enable pressure waves to enter towards the pressure-detection structure 4.

A rear surface 10b of the same package 10 may be defined by a rear surface 12b of the aforesaid third die 12, or, as illustrated here, by a distinct substrate 17, having the function of a base for the package 10, and appropriate electrical-connection elements 18 (in the form of conductive pads or bumps) may be formed on this rear surface 10b for electrical connection to an external system (for example, to an electronic apparatus that uses the microelectromechanical sensor device 100 for purposes of joint detection of pressure and of one or more inertial quantities, such as an acceleration or an angular velocity).

Through vias 19, connected to the aforesaid stack 1 by respective electrical-connection wires 19', are advantageously made through the third die 12, or, as illustrated here, through the aforesaid distinct substrate 17, for connection to the aforesaid electrical-connection elements 18.

In greater detail, the first die 2 comprises a substrate 20 of semiconductor material, in particular silicon, having a front surface 20a and a rear surface 20b, which extend in a horizontal plane xy and are separated from one another along a vertical axis z, orthogonal to the horizontal plane xy.

The pressure-detection structure 4 comprises a buried cavity 22, buried and entirely contained in the substrate 20 and arranged at the front surface 20a, from which it is separated by a membrane 24, having a small thickness along the vertical axis z. For instance, the thickness of the membrane 24 may have values comprised between 2 and 10 µm (along the aforesaid vertical axis z), with the buried cavity 22 having a depth comprised between 2 and 5 µm.

In particular, the membrane 24, which constitutes a surface portion of the substrate 20, at the front surface 20a, has a first main surface 24a that forms part of the same front surface 20a and a second main surface 24b, facing the buried cavity 22.

The buried cavity 22 is hence separated and isolated from the front surface 20a of the first die 2 by the aforesaid membrane 24 and moreover separated and isolated from the rear surface 20b by a monolithic body 25, constituted by the underlying portion of the substrate 20 (i.e., by a compact and uniform region of material, for example, monocrystalline silicon). The aforesaid buried cavity 22 hence forms a buried environment, entirely contained and isolated within the first die 2, not accessible from the outside of the same first die 2.

In a possible embodiment, the pressure-detection structure 4 further comprises piezoresistor elements 26, which are formed, for example, by doped diffused regions, and are arranged in the membrane 24, at the corresponding first surface 24a, in a peripheral position with respect to the same membrane 24.

The piezoresistor elements 26, in a way not illustrated in detail, may for example be electrically connected in a Wheatstone-bridge configuration, to output an electrical signal indicative of the deformation of the membrane 24 as a result of the incident pressure waves (and hence indicative of the pressure value).

As an alternative, the pressure-detection structure 4 may be of a capacitive type, the displacement of the membrane 24 in this case causing a variation of capacitive coupling between an associated arrangement of mobile detection electrodes, coupled to the membrane 24 (or constituted by the membrane, or by part of the same membrane), and a corresponding arrangement of fixed detection electrodes.

The pressure-detection structure 4 comprises one or more output pads (the aforesaid pads 13a'), which are, for example, electrically connected to the output of the aforesaid Wheatstone bridge or to the aforesaid detection electrodes, and are arranged on the front surface 20a, in a dielectric layer 27, whether single or composite, which coats and electrically insulates the same front surface 20a.

In this embodiment, underneath the buried cavity 22 (with respect to the vertical axis z) and at the rear surface 20b, the first die 2 moreover has a facing cavity 28, which constitutes a recess of the aforesaid rear surface 20b and faces the underlying second die 6 in the aforesaid stack 1.

At the same rear surface 20b, laterally with respect to the facing cavity 28, the first die 2 has bonding portions 29 of the substrate 20, which are designed for bonding to the aforesaid second die 6, by means of bonding regions 29', for example, of glass-frit or other appropriate material.

In detail, the second die 6 comprises a respective substrate 30 of semiconductor material, in particular silicon, having a respective front surface 30a and a respective rear surface 30b, which extend in the horizontal plane xy and are separated from one another along the vertical axis z.

The inertial detection structure 8 comprises a suspended structure 32, arranged on the front surface 30a, separated from the substrate 30 by a separation cavity 34.

This suspended structure 32 is made in a structural layer 33, for example made of polysilicon, formed on the substrate 30 and defined so as to provide suspended elements, for example, one or more suspended masses, detection electrodes, and elastic elements, suspended above the separation cavity 34 and configured so as to allow a movement by the inertial effect.

The inertial detection structure 8 further comprises: appropriate conductive leads or paths 35 on the substrate 30 (and/or formed in a surface portion of the substrate 30 itself at the front surface 30a), insulated by a surface dielectric layer 36 set on the same front surface 30a; and one or more electrical-connection pads (the aforesaid pads 13b'), coupled to the conductive leads or paths 35 and formed on the structural layer 33, laterally with respect to the suspended structure 32, in particular in a position not overlaid by the first die 2 in the aforesaid stack 1.

The structure described for the wafer-level integration of the pressure-detection structure 4 and of the inertial detection structure 8 allows to obtain a reduction of the number of substrates in the microelectromechanical sensor device 100 (equal to two) and hence a reduction in the thickness of the stack 1 in the direction of the vertical axis z and in the consequent thickness of the package 10.

Furthermore, the pressure-detection structure 4 and the inertial detection structure 8 may be made independently, and without them affecting one another with respect to the manufacturing process, it hence being possible to optimize them individually and independently relating to the corresponding performance.

Likewise, it is advantageous the possibility of independent manufacturing with specific manufacturing steps of the ASIC in the third die 12.

The solution described moreover enables total independence between the buried cavity 22, associated to pressure detection, and the hermetic cavity (formed jointly by the separation cavity 34 and by the communicating facing cavity 28), associated to inertial detection; in this way, the pressure in the buried cavity 22 is independent of the operating requirements of the hermetic cavity.

The depth (along the vertical axis z) of the hermetic cavity associated with inertial detection is moreover independent of the thickness of the substrate 20 of the first die 2.

The structure described is moreover robust from a mechanical standpoint both during manufacturing and during its operation, given that the cap for protecting the inertial sensor is constituted by a thick silicon layer (represented by the aforesaid substrate 20 of the first die 2).

A more detailed description of some specific steps of the manufacturing process is now presented, in particular as regards bonding of the wafers of semiconductor material in which the pressure-detection structure 4 and the inertial detection structure 8 are provided and subsequent formation of the aforesaid stack 1 by dicing of the stacked wafers.

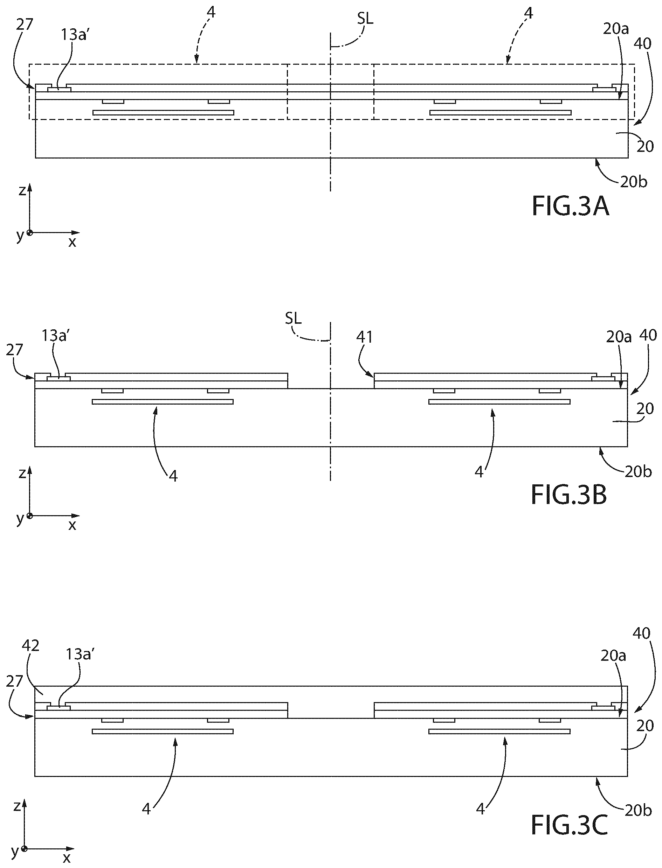

In this respect, Figure 3A shows a first wafer 40 of semiconductor material, in particular silicon, in which a plurality of the aforesaid first pressure-detection structures 4 (two of them are illustrated in Figure 3A, by way of example) have already been provided, with known process steps.

These pressure-detection structures 4 are separated from one another by respective scribe lines SL, along which wafer dicing operations will be carried out.

Each pressure-detection structure 4 may be obtained, for example, with the process described in EP 1 324 382 B1, filed in the name of the present Applicant.

In brief, this process envisages definition, by appropriate masking, of an etching area corresponding to the area that will be occupied by the buried cavity 22 and having an extension corresponding to the extension of the membrane 24 that will be formed on the buried cavity 22. This etching mask comprises a plurality of mask portions, for example, hexagonal-shaped, defining a lattice, for example, a honeycomb lattice.

Using the etching mask, an anisotropic chemical etch of the substrate 20 is performed, following upon which trenches are formed, which communicate with one another and delimit a plurality of columns. The trenches form an open region of complex shape (corresponding to the lattice of the etching mask), in which the columns (having a shape corresponding to the mask portions) extend.

Next, the etching mask is removed, and an epitaxial growth is carried out in a deoxidizing environment (typically, in an atmosphere with high concentration of hydrogen, preferably with trichlorosilane - SiHCl₃). Consequently, an epitaxial layer grows on the columns and closes at the top the aforesaid open region formed by the trenches.

A step of thermal annealing is then carried out, for example, for a duration of 30 minutes at a temperature of 1190°C, preferably in a reducing atmosphere, typically a hydrogen atmosphere. The annealing step causes a migration of silicon atoms that tend to move into a position of lower energy. Consequently, and also thanks to the short distance between the columns, the silicon atoms migrate completely from the portions of the columns present within the aforesaid open region formed by the trenches, and a buried region is formed starting from this open region.

In particular, the buried region defines the aforesaid buried cavity 22, inside which, as a result of the process steps described, an environment with controlled atmosphere is created, containing residual gas (for example, hydrogen and silane) at a desired pressure.

On the buried region a layer of monocrystalline silicon remains, constituted in part by silicon atoms grown epitaxially and in part by migrated silicon atoms, which forms the aforesaid membrane 24.

As illustrated in Figure 3B, the bonding process then envisages etching of the dielectric layer 27 in the region of the scribe lines SL for definition of an access opening 41, which leaves the front surface 20a of the substrate 20 exposed.

A sacrificial layer 42 of protective coating material constituted, for example, by a polyamide tape is then formed (Figure 3C) on the dielectric layer 27, and within the aforesaid access opening 41.

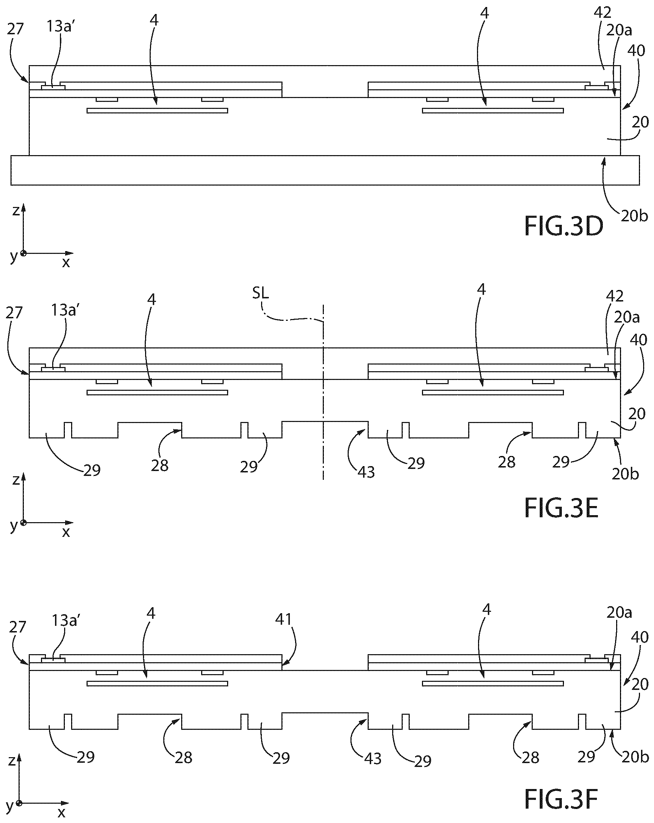

The wafer 40 is then subjected (Figure 3D) to a process of thinning from the back, for example, via grinding, which leads to reduction of the thickness in the direction of the vertical axis z, for example a reduction from approximately 700 µm to between 300 and 400 µm.

As illustrated in Figure 3E, the rear surface 20b of the resulting substrate 20 is subjected to a chemical etch for formation of the aforesaid facing cavities 28, for each of the pressure-detection structures 4, which extend in the substrate 20 by an amount comprised, for example, between 10 and 100 µm along the vertical axis z.

The same back etching leads to definition of the aforesaid bonding portions 29 of the substrate 20, which are to bond with the second die 6 and are separated by a respective further cavity 43 along the respective scribe line SL.

The sacrificial layer 42 is hence removed (Figure 3F) from the top surface of the wafer 40.

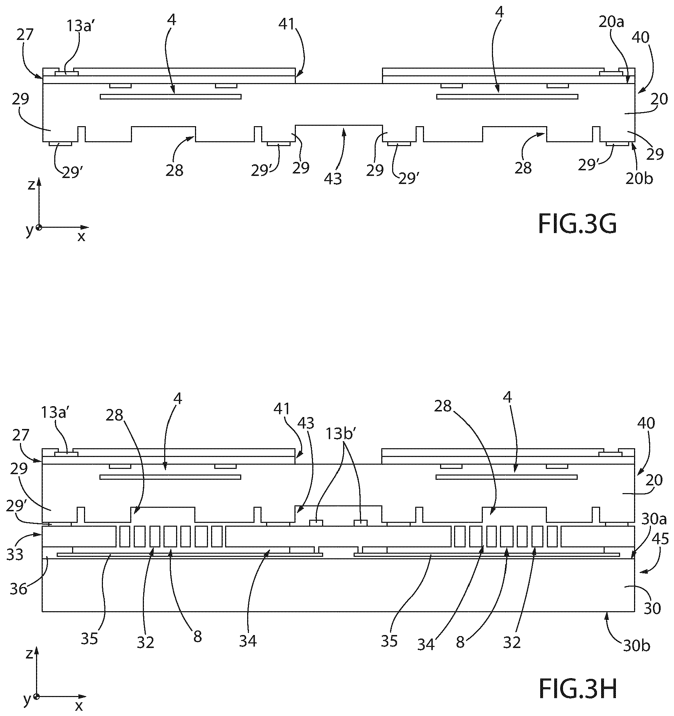

Afterwards, Figure 3G, the bonding regions 29' are formed, for example with techniques of printing and curing of a material such as glass-frit (or some other appropriate material).

The process then envisages (Figure 3H) bonding via the aforesaid bonding regions 29', between the first wafer 40 and a second wafer 45, of semiconductor material, in particular silicon, where a plurality of the aforesaid inertial detection structures 8 have already been provided, with known process steps. A compliant layer (here not illustrated) may be provisionally arranged on the first wafer 40 for preventing any surface damage during the aforesaid bonding step.

In brief, the inertial detection structures 8 may be formed with surface micromachining, using the so-called ThELMA (Thick Epipoly Layer for Microactuators and Accelerometers) process.

This process envisages deposition of a conductive layer on the substrate 30. This conductive layer is then patterned by a photolithographic process for definition of horizontal electrical interconnections to provide the aforesaid conductive leads or paths 35.

A sacrificial layer of silicon oxide is then deposited and patterned on the aforesaid conductive layer. Next, an epitaxial growth of the structural layer 33, for example made of polysilicon, is carried out, which is to form the suspended structure 32 and corresponding anchoring elements (which extend through openings previously defined in the sacrificial layer until the conductive layer is contacted).

The structural layer 33 is then defined by trench etching, for the formation of trenches, which define what will be the suspended elements of the aforesaid suspended structure 32 (for example, one or more suspended masses, capacitively coupled detection electrodes, elastic suspension elements).

Then, removal of the oxide of the sacrificial layer is carried out by chemical etching performed through the trenches, for release of the suspended elements and definition of the separation cavity 34. The part of the same sacrificial layer that is not removed moreover forms the aforesaid surface dielectric layer 36 set on the front surface 30a of the substrate 30.

The coupling process may at this point envisage a step of thinning of the back of the second wafer 45, for example by grinding, to arrive, for example, at a thickness of the resulting substrate 30 ranging between 300 to 900 µm.

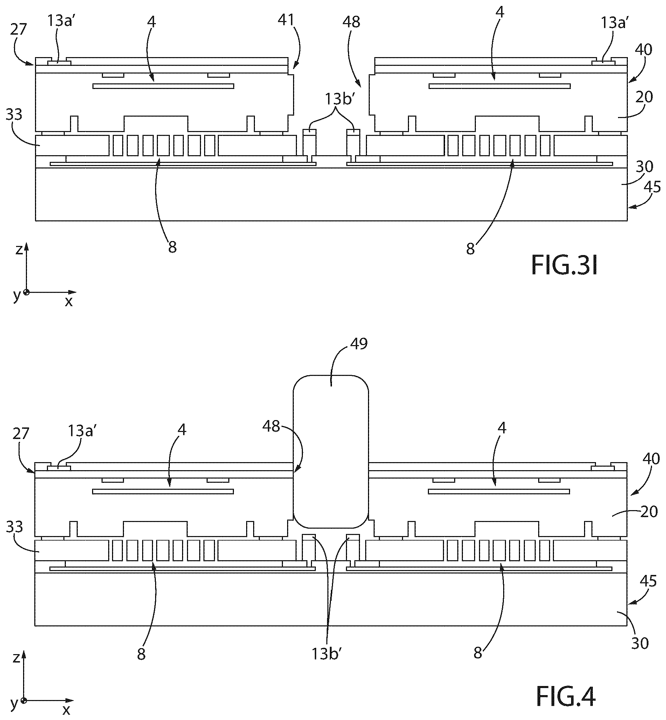

Then (Figure 3I), using an appropriate mask (not illustrated) on the first wafer 40, a step of dry chemical etching is carried out through the entire thickness of the first wafer 40 so as to open an access window 48 towards the underlying second wafer 45, in an area corresponding to the pads 13b' of the corresponding inertial detection structures 8.

This etch moreover proceeds through the structural layer 33 so as to insulate electrically from one another the pads 13b' that belong to distinct inertial detection structures 8 formed in the aforesaid second wafer 45 (as well as to enable suitable procedures for electrical testing of the operation of the inertial detection structures 8 at the wafer level).

The process then proceeds with dicing of the stack formed by the aforesaid first and second wafers 40, 45 in such a way as to define the stack 1 of the microelectromechanical sensor device 100, and then with packaging of the same stack 1 inside the corresponding package 10 (for example, being bonded to the third die 12, which integrates the electronic ASIC, as described previously and illustrated in the aforesaid Figures 1 and 2) .

As shown in Figure 4, an alternative to the aforesaid step of dry chemical etching through the entire thickness of the first wafer 40 may envisage, in the case where the pads 13b' belonging to the distinct inertial detection structures 8 have already been separated and isolated in the second wafer 45, opening of the aforesaid access window 48 by an operation of sawing from the front of the first wafer 40 using an appropriate blade, illustrated schematically and designated by 49.

The advantages of the solution proposed emerge clearly from the foregoing description.

In any case, it is emphasized that this solution enables reduction of the dimensions of the package 10 of the microelectromechanical sensor device 100, in particular as regards the thickness of the corresponding stack 1 in the direction of the vertical axis z.

Moreover, the solution described advantageously keeps separated the processes of manufacture of the pressure-detection and inertial detection structures 4, 8 and moreover of the associated ASIC, so as to ensure a desired flexibility and independence in the definition of the corresponding mechanical and electrical characteristics.

Finally, it is clear that modifications and variations may be made to what has been described and illustrated herein, without thereby departing from the scope of the present invention, as defined in the annexed claims.

In particular, it is again emphasized that the solution described enables wafer-level integration within a same package of different MEMS sensors having different technologies of implementation, these sensors possibly also differing in number and type from the pressure and inertial sensors to which reference has been made previously in particular detail.

## Claims

1. A process for manufacturing a microelectromechanical sensor device (100), comprising:
forming a pressure-detection structure (4) in a first wafer (40) of semiconductor material;
forming an inertial detection structure (8) in a second wafer (45) of semiconductor material, the inertial detection structure (8) having contact pads (13b');
coupling said first wafer (40) stacked on said second wafer (45);
carrying out dicing of said first and second wafers (40, 45) so as to obtain a stack (1) of a first die (2) that integrates said pressure-detection structure (4) and a second die (6) that integrates said inertial detection structure (8), said first die (2) constituting a cap for said inertial detection structure (8) and being bonded to said second die (6) so as to define a hermetic cavity (28, 34),
wherein forming said pressure-detection structure (4) comprises defining in said first wafer (40) a first substrate (20) that has a front surface (20a) and a rear surface (20b) and forming a buried cavity (22), which is buried and entirely contained in the first substrate (20) and is arranged at the front surface (20a), from which it is separated by a membrane (24), so that, in said stack (1), said buried cavity (22) is distinct and separate from said hermetic cavity (28, 34),
**characterised by** further comprising, after bonding between said first and second wafers (40, 45), opening an access window (48) through said first wafer (40) towards the underlying second wafer (45), at an area corresponding to the contact pads (13b') of said inertial detection structure (8).

2. The process according to claim 1, wherein forming said pressure-detection structure (4) comprises, after formation of said buried cavity (22), carrying out an etch from the back of said substrate (20) so as to form, at said rear surface (20b), a facing cavity (28), which constitutes a recess of the aforesaid rear surface (20b) and faces said second die (6) in said stack (1) and contributes to the definition of said hermetic cavity.

3. The process according to claim 2, wherein forming said inertial detection structure (8) comprises: defining in said second wafer (45) a second substrate (30), which has a respective front surface (30a) and a respective rear surface (30b); forming a structural layer (33) arranged above said respective front surface (30a) of the second substrate (30); and defining said structural layer (33) so as to form a suspended structure (32), separated from said respective front surface (30a) by a separation cavity (34); wherein, in said stack (1), said separation cavity (34) and said facing cavity (28) jointly define said hermetic cavity.

4. The process according to claim 3, further comprising forming, laterally with respect to the facing cavity (28) and at said rear surface (20b), bonding portions (29), bonded with said second die (6) by regions made of bonding material (29').

5. The process according to claim 4, further comprising bonding said bonding portions (29) to said structural layer (33) laterally and externally with respect to said suspended structure (32).

6. The process according to any of the preceding claims, wherein forming said access window (48) comprises one of the following steps: carrying out a dry chemical etch of said first wafer (40) through the entire thickness thereof, said etch further proceeding through said structural layer (33) of said second wafer (45) so as to insulate electrically from one another said contact pads (13b'); or opening said access window (48) by an operation of sawing from the front of said first wafer (40).

7. The process according to any of the preceding claims, further comprising mechanically coupling to said stack (1) a third die (12), integrating an electronic circuit; and electrically coupling said electronic circuit to the first die (2) and the corresponding pressure-detection structure (4) and to the second die (6) and the corresponding inertial detection structure (8) by respective electrical-connection wires (14a, 14b).

8. The process according to claim 7, further comprising forming a package (10) that houses said stack (1); wherein forming a package (10) comprises forming a coating (15); wherein a front surface (10a) of the package (10), defined by said coating (15), has an access hole (16) to enable entry of pressure waves towards the pressure-detection structure (4) in the first die (2).

9. The process according to any of the preceding claims, wherein said inertial detection structure (8) provides one or more of the following MEMS sensors: an accelerometer; a gyroscope; a resonator; or an appropriate combination of said MEMS sensors.

## Patentansprüche

1. Verfahren zur Herstellung einer mikroelektromechanischen Sensorvorrichtung (100), umfassend:
Bilden einer Druckerkennungsstruktur (4) in einem ersten Wafer (40) aus Halbleitermaterial;
Bilden einer Trägheitserkennungsstruktur (8) in einem zweiten Wafer (45) aus Halbleitermaterial, wobei die Trägheitserkennungsstruktur (8) Kontaktpads (13b') aufweist;
Koppeln des ersten Wafers (40), der auf dem zweiten Wafer (45) gestapelt ist;
Durchführen des Würfelns des ersten und des zweiten Wafers (40, 45), um einen Stapel (1) aus einem ersten Chip (2), in den die Druckerkennungsstruktur (4) integriert ist, und einem zweiten Chip (6), in den die Trägheitserkennungsstruktur (8) integriert ist, zu erhalten, wobei der erste Chip (2) eine Abdeckung für die Trägheitserkennungsstruktur (8) bildet und mit dem zweiten Chip (6) verbunden ist, um einen hermetischen Hohlraum (28, 34) zu definieren,
wobei das Bilden der Druckerkennungsstruktur (4) das Definieren eines ersten Substrats (20), das eine vordere Oberfläche (20a) und eine hintere Oberfläche (20b) aufweist, in dem ersten Wafer (40) und das Bilden eines vergrabenen Hohlraums (22) umfasst, der in dem ersten Substrat (20) vergraben und vollständig enthalten ist und an der vorderen Oberfläche (20a) angeordnet ist, von der sie durch eine Membran (24) getrennt ist, sodass in dem Stapel (1) der vergrabene Hohlraum (22) von dem hermetischen Hohlraum (28, 34) getrennt ist,
**dadurch gekennzeichnet, dass** er nach dem Verbinden des ersten und des zweiten Wafers (40, 45) ferner das Öffnen eines Zugangsfensters (48) durch den ersten Wafer (40) in Richtung des darunterliegenden zweiten Wafers (45) in einem Bereich umfasst, der den Kontaktpads (13b') der Trägheitserkennungsstruktur (8) entspricht.

2. Verfahren nach Anspruch 1, wobei das Bilden der Druckerkennungsstruktur (4) nach dem Bilden des vergrabenen Hohlraums (22) das Durchführen einer Ätzung von der Rückseite des Substrats (20) aus umfasst, um an der hinteren Oberfläche (20b) einen gegenüberliegenden Hohlraum (28) zu bilden, der eine Vertiefung der vorgenannten hinteren Oberfläche (20b) darstellt und dem zweiten Chip (6) im Stapel (1) zugewandt ist und zur Definition des hermetischen Hohlraums beiträgt.

3. Verfahren nach Anspruch 2, wobei das Bilden der Trägheitserkennungsstruktur (8) umfasst: Definieren eines zweiten Substrats (30), das eine jeweilige vordere Oberfläche (30a) und eine jeweilige hintere Oberfläche (30b) aufweist, in dem zweiten Wafer (45); Bilden einer Strukturschicht (33), die oberhalb der jeweiligen vorderen Oberfläche (30a) des zweiten Substrats (30) angeordnet ist; und Definieren der Strukturschicht (33), so dass sie eine aufgehängte Struktur (32) bildet, die von der jeweiligen vorderen Oberfläche (30a) durch einen Trennhohlraum (34) getrennt ist; wobei in dem Stapel (1) der Trennhohlraum (34) und der gegenüberliegende Hohlraum (28) gemeinsam den hermetischen Hohlraum definieren.

4. Verfahren nach Anspruch 3, ferner umfassend das Bilden von Verbindungsabschnitten (29), die mit dem zweiten Chip (6) durch Bereiche aus Verbindungsmaterial (29') verbunden sind, seitlich in Bezug auf den gegenüberliegenden Hohlraum (28) und an der hinteren Oberfläche (20b).

5. Verfahren nach Anspruch 4, ferner umfassend das Verbinden der Verbindungsabschnitte (29) mit der Strukturschicht (33) seitlich und außen in Bezug auf die aufgehängte Struktur (32).

6. Verfahren nach einem der vorhergehenden Ansprüche, wobei das Bilden des Zugangsfensters (48) einen der folgenden Schritte umfasst: Durchführen eines trockenen chemischen Ätzens des ersten Wafers (40) durch seine gesamte Dicke, wobei das Ätzen weiter durch die Strukturschicht (33) des zweiten Wafers (45) fortgesetzt wird, um die Kontaktpads (13b') elektrisch voneinander zu isolieren; oder Öffnen des Zugangsfensters (48) durch einen Sägevorgang von der Vorderseite des ersten Wafers (40).

7. Verfahren nach einem der vorhergehenden Ansprüche, ferner umfassend das mechanische Koppeln eines dritten Chips (12), in den eine elektronische Schaltung integriert ist, mit dem Stapel (1); und das elektrische Koppeln der elektronischen Schaltung mit dem ersten Chip (2) und der entsprechenden Druckerkennungsstruktur (4) und mit dem zweiten Chip (6) und der entsprechenden Trägheitserkennungsstruktur (8) durch jeweilige elektrische Verbindungsdrähte (14a, 14b).

8. Verfahren nach Anspruch 7, ferner umfassend das Bilden einer Verpackung (10), die den Stapel (1) aufnimmt; wobei das Bilden einer Verpackung (10) das Bilden einer Beschichtung (15) umfasst; wobei eine vordere Oberfläche (10a) der Verpackung (10), definiert durch die Beschichtung (15), ein Zugangsloch (16) aufweist, um das Eindringen von Druckwellen in Richtung der Druckerkennungsstruktur (4) im ersten Chip (2) zu ermöglichen.

9. Verfahren nach einem der vorhergehenden Ansprüche, wobei die Trägheitserkennungsstruktur (8) einen oder mehrere der folgenden MEMS-Sensoren bereitstellt: einen Beschleunigungsmesser, ein Gyroskop, einen Resonator oder eine geeignete Kombination aus den MEMS-Sensoren.

## Revendications

1. Procédé de fabrication d'un dispositif de capteur microélectromécanique (100), comprenant :
de former une structure de détection de pression (4) dans une première plaquette (40) de matériau semi-conducteur ;
de former une structure de détection inertielle (8) dans une seconde plaquette (45) de matériau semi-conducteur, la structure de détection inertielle (8) comportant des plots de contact (13b') ;
de coupler ladite première plaquette (40) empilée sur ladite seconde plaquette (45) ;
de réaliser le découpage en dés desdites première et seconde plaquettes (40, 45) de façon à obtenir un empilement (1) d'un premier dé (2) qui intègre ladite structure de détection de pression (4) et d'un second dé (6) qui intègre ladite structure de détection inertielle (8), ledit premier dé (2) constituant un couvercle pour ladite structure de détection inertielle (8) et étant collé audit second dé (6) de façon à définir une cavité hermétique (28, 34),
dans lequel former ladite structure de détection de pression (4) comprend de définir dans ladite première plaquette (40) un premier substrat (20) qui comporte une surface avant (20a) et une surface arrière (20b) et de former une cavité enterrée (22), qui est enterrée et entièrement contenue dans le premier substrat (20) et est agencée au niveau de la surface avant (20a), de laquelle elle est séparée par une membrane (24), de telle manière que, dans ledit empilement (1), ladite cavité enterrée (22) est distincte et séparée de ladite cavité hermétique (28, 34),
**caractérisé en ce qu'**il comprend en outre, après le collage entre lesdites première et seconde plaquettes (40, 45), d'ouvrir une fenêtre d'accès (48) à travers ladite première plaquette (40) vers la seconde plaquette (45), au niveau d'une zone correspondant aux plots de contact (13b') de ladite structure de détection inertielle (8).

2. Procédé selon la revendication 1, dans lequel former ladite structure de détection de pression (4) comprend, après la formation de ladite cavité enterrée (22), de réaliser une gravure depuis l'arrière dudit substrat (20) de façon à former, au niveau de ladite surface arrière (20b), une cavité opposée (28), qui constitue un évidement de la surface arrière (20b) susmentionnée et fait face audit second dé (6) dans ledit empilement (1) et contribue à la définition de ladite cavité hermétique.

3. Procédé selon la revendication 2, dans lequel former ladite structure de détection inertielle (8) comprend : de définir dans ladite seconde plaquette (45) un second substrat (30), qui comporte une surface avant (30a) respective et une surface arrière (30b) respective ; de former une couche structurelle (33) agencée au-dessus de ladite surface avant (30a) respective du second substrat (30) ; et de définir ladite couche structurelle (33) de façon à former une structure suspendue (32), séparée de ladite surface avant (30a) respective par une cavité de séparation (34) ; dans lequel, dans ledit empilement (1), ladite cavité de séparation (34) et ladite cavité opposée (28) définissent de manière jointe ladite cavité hermétique.

4. Procédé selon la revendication 3, comprenant en outre de former, latéralement par rapport à la cavité opposée (28) et au niveau de ladite surface arrière (20b), des parties de collage (29), collées avec ledit second dé (6) par des régions faites d'un matériau de collage (29').

5. Procédé selon la revendication 4, comprenant en outre de coller lesdites parties de collage (29) sur ladite couche structurelle (33) latéralement et extérieurement par rapport à ladite structure suspendue (32).

6. Procédé selon l'une quelconque des revendications précédentes, dans lequel former ladite fenêtre d'accès (48) comprend l'une des étapes suivantes : réaliser une gravure chimique sèche de ladite première plaquette (40) à travers toute l'épaisseur de celle-ci, ladite gravure passant en outre à travers ladite couche structurelle (33) de ladite seconde plaquette (45) de façon à isoler électriquement les uns des autres lesdites plots de contact (13b') ; ou ouvrir ladite fenêtre d'accès (48) par une opération de sciage depuis l'avant de ladite première plaquette (40).

7. Procédé selon l'une quelconque des revendications précédentes, comprenant en outre de coupler mécaniquement audit empilement (1) un troisième dé (12), intégrant un circuit électronique ; et de coupler électriquement ledit circuit électronique au premier dé (2) et à la structure de détection de pression (4) correspondante et au second dé (6) et à la structure de détection inertielle (8) correspondante par des fils de connexion électriques (14a, 14b) respectifs.

8. Procédé selon la revendication 7, comprenant en outre de former un boîtier (10) qui loge ledit empilement (1) ; dans lequel former un boîtier (10) comprend de former un revêtement (15) ; dans lequel une surface avant (10a) du boîtier (10), définie par ledit revêtement (15), comporte un trou d'accès (16) pour permettre l'entrée d'ondes de pression à travers la structure de détection de pression (4) dans le premier dé (2).

9. Procédé selon l'une quelconque des revendications précédentes, dans lequel ladite structure de détection inertielle (8) fournit un ou plusieurs des capteurs MEMS suivants ; un accéléromètre ; un gyroscope ; un résonateur ; ou une combinaison appropriée desdits capteurs MEMS.
